# FASCICULE DE BREVET EUROPEEN

(11) **EP 2 339 909 B1**
(45) Date de publication et mention de la délivrance du brevet: **02.07.2014**
(21) Numéro de dépôt: 10196058.1
(22) Date de dépôt: 20.12.2010
(51) Int. Cl.: H05K 7/20, F24F 7/00

(54) **Procédé et dispositif pour réduire la consommation d'énergie d'un centre comportant des équipements énergivores.**
Verfahren und Vorrichtung zur Reduzierung des Energieverbrauchs eines Zentrums, das mit energiefressenden Geräten ausgestattet ist
Method and device for reducing the power consumption of a centre comprising energy-consuming equipment.

(30) Priorité: 22.12.2009 FR 0959429; 19.02.2010 FR 1051219
(43) Date de publication de la demande: 29.06.2011
(73) Titulaire: Atrium Data, 75008 Paris (FR)
(72) Inventeur: Dernis, Michel, 92200, Neuilly sur Seine (FR); Duflos, Thierry, 92300, Levallois-Perret (FR)
(74) Mandataire: Derambure, Christian

(56) Documents cités:
- DE-A1-102007 051 048
- DE-U1-202004 003 309
- US-A1- 2009 254 763

## Description

L'invention vise à réduire la consommation d'énergie d'un centre comportant des équipements énergivores, tels que des équipements électroniques, informatiques ou de télécommunications, à savoir la consommation d'énergie liée au conditionnement d'air requis par l'exploitation d'un tel centre. Un tel centre est par exemple un centre de traitement de données (connu couramment sous le nom de data centre ou data center). Toutefois, l'invention s'applique à tout autre type de centre comportant des équipements énergivores.

Plus particulièrement, l'invention a pour objet, en premier lieu, un centre, tel que centre de traitement de données, comportant au moins une salle principale où se trouvent une pluralité de rangées de baies sur lesquelles sont installés une pluralité d'équipements fonctionnels énergivores ayant d'une part des passages d'entrée d'air situés fonctionnellement du côté de leur face avant et des passages de sortie d'air situés du côté de leur face arrière et d'autre part des moyens de refroidissement par ventilation associés aux passages d'entrée et de sortie d'air. L'invention a pour objet, en deuxième lieu, une cheminée d'extraction d'air chaud, spécialement destinée à être intégrée à un tel centre. L'invention a pour objet, en troisième lieu, un procédé de conditionnement d'air d'un tel centre.

Un tel centre de traitement de données occupe, selon son importance, une ou plusieurs salles, voire la totalité des salles (couramment appelées « salles informatiques ») d'un immeuble. Une telle salle (dénommée par la suite et par convention dans le cadre de l'invention « salle principale ») est équipée d'une pluralité de meubles formant des bâtis (couramment appelés « baies » ou « racks »), sur lesquels sont installés - portés, fixés..., le cas échéant empilés, superposés... - les coffrets des équipements électroniques, informatiques ou de télécommunications destinés au fonctionnement des différents services hébergés dans le centre (de tels équipements énergivores sont dénommés par la suite et par convention dans le cadre de l'invention « équipements fonctionnels »). Ces équipements fonctionnels comportent nombre de liaisons électriques, de télécommunications ou de transmissions de données destinées à être associées à des liaisons correspondantes prévues dans la salle principale. Par exemple, dans une réalisation possible, les baies sont elles-mêmes câblées pour permettre le câblage des équipements fonctionnels.

Les salles principales permettent de loger un grand nombre d'équipements fonctionnels sur une surface de plancher donnée. En fonctionnement, de tels équipements fonctionnels génèrent une quantité appréciable de chaleur qui doit être évacuée afin que le fonctionnement des équipements fonctionnels ne soit pas affecté. À cet effet, un tel équipement fonctionnel est pourvu d'un ou de plusieurs passages d'entrée d'air de ventilation situés fonctionnellement du côté d'une de ses faces - la face avant - et d'un ou de plusieurs passages de sortie d'air situés du côté d'une autre de ses faces, opposée à la précédente, - la face arrière -. Un tel équipement fonctionnel est pourvu d'autre part de moyens de refroidissement par ventilation associés aux passages d'entrée et de sortie. Par exemple, et sans que cela ne soit limitatif, de tels moyens de refroidissement incluent des ventilateurs aptes, en combinaison avec les passages d'entrée et de sortie d'air, à faire passer sur l'équipement fonctionnel de l'air de ventilation tempéré qui refroidit l'équipement fonctionnel, du moins évacue la chaleur qu'il produit lors de son fonctionnement, l'air ainsi chauffé étant ensuite évacué.

Typiquement, des baies telles que celles précédemment considérées sont au format 19 pouces (mais elles peuvent être d'un autre format) et elles comportent des structures porteuses, des panneaux latéraux, et des agencements tels que des tiroirs, des glissières, des panneaux, des passe-câbles, des portes avant et/ou arrière..., aptes à permettre l'installation - portage, fixation ..., empilage, superposition... - et le câblage des équipements fonctionnels. Toutefois, ces baies peuvent aussi être dédiées à un système construit par les équipementiers (gros serveurs, calculateurs, unités de stockage de données...) et bien qu'identifiées comme équipement de type « standalone » restent dans cette application considérée au même titre que les baies précédemment mentionnées.

D'autre part, le plus souvent, les baies comportent des passages d'entrée d'air situés fonctionnellement du côté d'une de leur face - la face avant - et des passages de sortie d'air situés du côté de leur autre face - la face arrière - et/ou du côté de leur face supérieure (parfois appelé « toit de baie »), le cas échéant avec des portes avant et/ou arrière. Ces baies sont disposées et structurées de manière que les coffrets des équipements fonctionnels forment des piles simples. Elles sont disposées et agencées pour former des rangées simples séparées par des allées avant et des allées arrière, de manière à ménager un accès pour chaque coffret d'équipement fonctionnel.

Un tel accès est nécessaire pour mettre en place et enlever, respectivement, les coffrets des équipements fonctionnels, ainsi que pour les branchements électriques et informatiques ou de télécommunications, mais également pour le réglage, le contrôle, et enfin pour la ventilation.

D'autre part, le centre de traitement comporte des moyens de conditionnement d'air aptes à procurer aux faces avant des équipements fonctionnels de l'air filtré dont le débit, la température T₂ _ par exemple de l'ordre de 21 °C - et le degré hygrométrique sont maintenus ou compris dans les plages de débits, de températures et de degrés hygrométriques adaptées au fonctionnement optimal des équipements fonctionnels.

Dans certaines réalisations, les baies reposent sur un faux-plancher surélevé, ménageant un espace pour le passage et la distribution des câbles électriques et électroniques ou de télécommunications mais également pour la circulation et la distribution de l'air de ventilation. Dans d'autres réalisations, cet espace de circulation, de distribution et de passage est placé en partie haute, en plafond.

Historiquement, les équipements étaient implantés dans les salles en fonction de la configuration et des besoins, sans souci de l'impact énergétique. Le conditionnement d'air de la salle était le plus souvent réalisé au moyen d'armoires à soufflage inversé reprenant l'air ambiant et/ou dans le faux-plafond et soufflant de l'air frais dans le faux-plancher mis en surpression. Grâce à des dalles perforées et/ou des grilles réglables réparties dans la salle l'air frais était dissipé dans la salle pour maintenir une température ambiante dans les conditions indiquées préalablement.

Par la suite, les équipements ont été implantés en rangées, comme indiqué plus haut, notamment selon une structure répétitive face avant / face arrière - face avant / face arrière. Le conditionnement d'air était le plus souvent réalisé au moyen d'armoires à soufflage inversé comme indiqué précédemment. Cette solution a vite trouvé ses limites du fait de l'existence de points chauds, par suite de l'augmentation de la puissance des centres de traitement de données.

Par la suite, les équipements ont été implantés dos à dos pour former des couloirs froids et des couloirs chauds, toutes les faces avant des équipements de deux rangées débouchant de part et d'autre d'un couloir froid et toutes les faces arrière des équipements de deux rangées débouchant de part et d'autre d'un couloir chaud. Avec un tel arrangement, on a pu considérer qu'il n'était plus décisif de viser une température moyenne de 21 °C, mais d'avoir dans les couloirs froids une température maintenue à 21 °C ou 22 °C, tandis que l'on pouvait accepter d'avoir dans les couloirs chauds une température pouvant atteindre 35 °C, en fonction des caractéristiques des équipements installés.

Il a été proposé de perfectionner cet arrangement en confinant les couloirs froids au moyen de portes disposées aux extrémités des couloirs froids et d'une couverture disposée par-dessus. Cet arrangement permet de garder le froid et d'éviter sa déperdition.

L'un des problèmes cruciaux de tels centres est l'importance de la consommation énergétique électrique (d'aucuns estiment que dans les pays les plus développés, les centres de traitement de données consomment plusieurs pour cent de la consommation énergétique totale). Cette consommation est élevée pour nombre de raisons. D'une part, la densité des équipements fonctionnels tend à augmenter et ces équipements sont énergivores en fonctionnement, alors que la demande de puissance de calcul tend à croître. D'autre part, le fonctionnement optimal des équipements fonctionnels suppose qu'ils soient alimentés avec de l'air filtré dont le débit, la température et le degré hygrométrique sont maintenus ou compris dans des plages de débits, de températures et de degrés hygrométriques adaptées. Compte tenu de la chaleur générée par les équipements fonctionnels lorsqu'ils sont en fonctionnement, on a été amené à prévoir des dispositifs de conditionnement d'air de plus en plus puissants, eux-mêmes de plus en plus énergivores. Ainsi, on estime que la part principale de la consommation totale en énergie d'un centre de traitement de données, en dehors de la consommation en énergie des équipements informatiques électroniques et de télécommunications, a pour origine le conditionnement d'air.

Le consortium GRID GREEN a conçu un indicateur de performance énergétique des centres de traitement de données : le PUE (acronyme de Power Usage Effectiveness). Cet indicateur mesure le ratio entre la dépense énergétique totale d'un centre de traitement de données et celle propre à ses équipements électroniques, informatiques ou de télécommunication. Par exemple, un PUE de 2 signifie que le centre de traitement de données pris dans son ensemble consomme deux fois plus d'énergie que les équipements qu'il héberge. Les membres du consortium GRID GREEN ont pour objectif d'atteindre un PUE de 1,6 à la fin de l'année 2009.

Les documents US 2009/0254763 et US 2009/0251860 posent le problème de la maîtrise de la consommation énergétique d'un centre de traitement de données. Ils décrivent à cette fin un centre de traitement de données comportant des unités de ressource incluant des moyens d'entrée d'air et des moyens de sortie d'air et incluant un groupe de modules de traitement de données comprenant le minimum de composants aptes à réaliser les fonctions principales de ces modules, un système de circulation d'air configuré pour recevoir et fournir de l'air extérieur non conditionné aux unités de ressource. Ce système de circulation d'air comporte un système de ventilation configuré pour diriger l'air chaud provenant des sorties d'air vers les entrées d'air, de manière qu'aux entrées d'air, l'air chaud soit mélangé avec de l'air extérieur non conditionné. Dans une réalisation, Il est prévu que les unités de ressource sont empilées sous la forme d'une tour verticale plutôt que juxtaposées horizontalement. Dans ce cas, il est prévu une cheminée d'extraction de l'air chaud soit par tirage naturel soit par un tirage assisté au moyen de ventilateurs.

Les solutions proposées par ces documents ne peuvent donner totalement satisfaction.

L'espace laissé libre autour des équipements est trop réduit, notamment pour le passage des câbles, mais également pour mettre en place et enlever, respectivement, les coffrets des équipements, ou assurer les modifications d'aménagement ou de branchement qui peuvent être nécessaires. L'agencement proposé ne semble donc pouvoir convenir qu'avec des équipements spécifiques, ce qui en limite considérablement l'intérêt et la portée.

Avec l'agencement décrit par ces documents, de l'air frais arrive sur une première face des équipements, puis est chauffé en traversant ces équipements et est ensuite rejeté depuis la seconde face des équipements pour être repris par des ventilateurs en position supérieure. L'air frais qui entre dans le module qui héberge les baies peut longer vers le haut la première face ou le côté des baies et être mélangé avec l'air chaud rejeté depuis la seconde face. Ce phénomène est accru car l'air passe là où la perte de charge est la moins importante et que les ventilateurs créent une dépression, tendant à aspirer non seulement l'air chaud rejeté mais également l'air frais. L'effet de tirage est amoindri par le fait que l'air chaud rejeté est mélangé avec de l'air plus frais mal canalisé. En outre, le tirage ne peut être qualifié de naturel par suite de la présence des ventilateurs. L'air rejeté par les ventilateurs est un mélange d'air chaud et d'air frais. Enfin, les ventilateurs eux-mêmes sont eux-aussi énergivores.

Tout cela, au total, nuit à l'efficacité et à l'efficience de l'agencement.

Il en est de même du fait des nombreux obstacles rencontrés par le flux d'air, via le faux-plancher, puis par les entrées d'air, ce qui augmente les pertes de charges et impose de prévoir des ventilateurs plus puissants, ce qui est consommateur d'un surcroît d'énergie et dégrade le PUE.

Il en est de même dans le cas où il est prévu que les unités de ressource sont empilées sous la forme d'une tour verticale plutôt que juxtaposées horizontalement, car alors les pertes de charge sont augmentées et les ventilateurs doivent fonctionner en permanence. Bien qu'il soit prévu dans cet agencement qu'une ou plusieurs turbines puissent être montées dans la cheminée, cette solution est purement théorique et ne correspond à aucune réalisation concrète.

Il en est de même dans le cas où il est prévu de réchauffer l'air frais amené s'il est trop froid, car alors de l'air chaud arrive dans un volume réduit par le haut de sorte que les équipements fonctionnels situés vers le haut reçoivent un air trop chaud et ceux situés vers le bas un air trop froid, un bon brassage de l'air et un contrôle suffisant de la température de l'air envoyé vers les équipements n'étant pas assuré. Par ailleurs, si l'air arrive sans traitement aucun, pour les équipements fonctionnels situés en base des baies par exemple, il peut se trouver à une température inférieure à celle du point de rosée de l'air ambiant et créer de la condensation soit sur les baies ou pire encore au sein des équipements fonctionnels sous tension. Inversement, aucune solution n'est proposée si l'air qui arrive se trouve à une température trop élevée pour remplir sa fonction de refroidissement.

Le document US 7 529 086 pose également le problème de l'efficacité et de l'efficience de la climatisation et du conditionnement d'air des centres de traitement de données. Ce document prévoit que deux rangées de baies sont agencées selon une structure face avant / face arrière - face arrière / face avant. Une enceinte comportant un toit et s'étendant entre les deux rangées de baies assure la collecte de l'air chaud provenant des faces arrière. Cet air chaud traverse des unités de refroidissement d'air, l'air ainsi refroidi étant relâché dans la salle où se trouvent les rangées de baies. L'agencement est tel que l'air se trouvant dans l'enceinte est maintenu à une pression substantiellement égale à celle de l'air se trouvant en dehors de l'enceinte. Il est également prévu d'amener de l'air frais aux faces avant de la pluralité de rangées de baies.

La solution proposée par ce document revient à traiter en température l'air dans le couloir chaud pour le rejeter dans la salle informatique avec une température adaptée. Cette solution ne peut être considérée comme pouvant apporter une contribution significative au problème posé, car les unités de refroidissement d'air sont énergivores et complémentaires aux armoires de climatisation usuellement installées dans les salles et d'autant plus énergivores qu'elles doivent traiter de l'air plus chaud si les équipements produisent plus de chaleur, ou qu'elles doivent traiter de l'air dont l'amenée aux équipements peut n'être pas nécessaire. De même cette solution impose un fonctionnement permanent des unités de refroidissement d'air ce qui représente une consommation d'énergie supplémentaire qui affecte le PUE.

Une solution proche de la précédente, mais sans enceinte de confinement chaude, est décrite dans le document US 2009/0207567 relatif à un agencement fonctionnant également sur le principe d'un circuit fermé qui ne tire pas avantage de l'air extérieur.

Le document US 2009/0210096 décrit un agencement dans lequel les rangées de baies reposent sur un faux-plancher. Cet agencement prévoit l'utilisation de l'air extérieur quand sa température et son taux d'humidité sont conformes aux plages de fonctionnement des équipements. L'air extérieur est pris directement au niveau des climatiseurs. Cette solution permet de ne pas refroidir l'air sur une plage de temps importante, mais toutefois elle utilise en permanence le ventilateur des climatiseurs avec les surconsommations liées aux pertes de charge dues à l'existence même d'un faux-plancher, à la structure de maintien qu'il comporte, à la présence de câbles et de canalisations obstruant l'espace se trouvant sous le faux-plancher.

Il est important de noter que plus la puissance thermique à dissiper est importante, plus le volume d'air frais à apporter doit l'être. Le volume d'air ainsi soufflé dans le faux-plancher, quand cette solution est utilisée, augmente proportionnellement avec la puissance à dissiper. Le faux-plancher étant réalisé de façon définitive à la mise en service du centre de traitement de données, la perte de charge représentée par les faux-plancher et les câbles qui y sont installés progressivement, augmente au fur et à mesure du taux d'occupation du centre de traitement de données et de l'évolution de la puissance thermique à dissiper, la perte de charge étant proportionnelle à la vitesse de l'air soufflé et à l'encombrement du faux-plancher.

L'état de la technique comprend également les documents DE 20 2004 003309, DE 10 2007 051048, US 2006/0168975, US 2009/0241578 et US 2007/0171613, la réalisation du Yokohama Third Center de la société Hitachi Data Systems Corporation qui permet d'atteindre un PUE de 1,6 en combinant un ensemble de moyens tels que centre de commande intégré, simulateur thermohydraulique optimisant le refroidissement, terrasse jardin créatrice d'ombre dans laquelle est placée le centre de traitement de données...

Le document DE 20 2004 vise un agencement comportant un carter à double paroi, fermé sur le dessus, dans le bas et sur les côtés, dans lequel sont logés des composants électroniques et à travers la face frontale perforée duquel est insufflé de l'air froid, qui circule autour des composants électroniques pour les refroidir, l'air chauffé sous l'effet du refroidissement étant évacué hors du carter au moyen de ventilateurs qui sont montés sur la paroi arrière du carter, caractérisé en ce que l'air chaud, collecté dans un collecteur monté sur la paroi arrière du carter, est évacué et transféré par l'intermédiaire d'un ou de plusieurs orifices ménagés dans ledit collecteur. Les côtés fermés du carter se rejoignent en formant un cercle et forment donc un cylindre à double paroi. L'ensemble du collecteur d'air sur la paroi arrière et la paroi intérieure est réalisé géométriquement de telle sorte qu'il possède une propriété d'amortissement du bruit des ventilateurs.

Le document DE 10 2007 051 048 vise une installation avec des sources de chaleur réparties dans l'espace, qui sont munies d'un système de refroidissement, comportant un espace de montage présentant un axe vertical central, dans lequel sont agencées les sources de chaleur, une ouverture d'évacuation d'air centrale symétrique de révolution autour de l'axe vertical central, qui est agencée dans une paroi supérieure de l'espace de montage, et une unité formant cheminée qui débouche dans l'ouverture d'évacuation d'air centrale et dont le volume intérieur est réalisé avec une symétrie de révolution par rapport à l'axe vertical central. La paroi supérieure est inclinée et la hauteur entre un fond de l'espace de montage et la paroi supérieure s'accroît en direction vers l'ouverture d'évacuation d'air.

Généralement parlant, le problème à la base de l'invention est donc de réduire de façon très significative la consommation d'énergie d'un centre de traitement de données et plus spécialement de réduire la part de la consommation d'énergie ayant le conditionnement d'air pour origine.

Plus spécialement, le problème est de s'affranchir des solutions connues qui impliquent d'avoir des faux-planchers. De s'affranchir des solutions connues qui reposent sur le principe d'un circuit fermé ou l'air chaud est refroidi pour être réinjecté ou sur le principe d'une extraction assistée. De s'affranchir de solutions conduisant à d'importantes pertes de charge.

Le problème à la base de l'invention est de pouvoir réduire de façon très significative la consommation d'énergie d'un centre de traitement de données - ou analogue -, à savoir la consommation d'énergie liée au conditionnement d'air requis par l'exploitation d'un tel centre, quels que soient les équipements électroniques, informatiques ou de télécommunication du centre, et sans nécessiter de les adapter et sans apporter des contraintes d'exploitation contraires au fonctionnement du centre et en respectant dans chaque pays les règles liées à la sécurité des personnes en cas d'évacuation incendie (zones trop confinées, cul de sac...) d'accessibilité aux équipements (empilement de modules limitant l'accessibilité à certains équipements), de compartimentage coupe-feu (augmentation des zones de détection et d'extinction incendie) et aux réglementations spécifiques à chaque pays lies à la sécurité en générale.

Le problème à la base de l'invention est d'atteindre ces résultats de façon économique en termes d'investissement et d'exploitation et de façon sûre.

À cet effet, l'invention a pour objet une cheminée d'extraction d'air chaud spécialement destinée à être intégrée à un centre de traitement de données.

Le centre de traitement de données, comporte au moins une salle principale où se trouvent une pluralité de rangées de baies sur lesquelles sont installés une pluralité d'équipements fonctionnels énergivores, tels que des équipements électroniques, informatiques ou de télécommunications, ayant d'une part des passages d'entrée d'air situés fonctionnellement du côté de leur face avant et des passages de sortie d'air situés du côté de leur face arrière et d'autre part des moyens de refroidissement par ventilation associés aux passages d'entrée et de sortie.

Ce centre est tel que :
- la disposition des baies et des équipements fonctionnels est telle qu'une paire au moins de deux rangées adjacentes, dont les faces dos à dos des équipements fonctionnels sont les faces arrière, définit un couloir chaud limité par ces faces arrière et où sont accessibles les passages de sortie d'air, dans lequel l'air est chaud, à une température T₃ supérieure à la température T₂ de l'air tempéré se trouvant dans la partie de la salle principale extérieure au ou aux couloirs chauds, et depuis laquelle sont accessibles les faces avant et les passages d'entrée d'air, r,
- il est prévu des moyens de conditionnement d'air aptes à procurer aux faces avant des équipements fonctionnels de l'air filtré dont le débit, la température T₂ et le degré hygrométrique sont maintenus ou compris dans les plages de débits, de températures et de degrés hygrométriques adaptées au fonctionnement optimal des équipements fonctionnels,
- le ou les couloirs chauds font partie d'une ou de plusieurs enceintes de confinement d'air chaud isolées de la partie de la salle principale extérieure à cette ou ces enceintes de confinement.

Ce centre est tel que les moyens des moyens de conditionnement d'air aptes à procurer aux équipements fonctionnels de l'air dont le débit est maintenu dans la plage de débits adaptée au fonctionnement optimal des équipements fonctionnels comprennent au moins une salle de mélange d'air et la combinaison des moyens de refroidissement par ventilation des équipements fonctionnels et de moyens de convection naturelle équipant le centre, tels que la cheminée d'extraction d'air chaud est dépourvue de ventilateurs d'extraction d'air chaud et/ou de ventilateurs d'amenée d'air frais.

La cheminée comporte :
- un conduit de longueur et de section aptes à maximiser la circulation de l'air par convection naturelle,
- une entrée amont d'extraction d'air apte à communiquer avec la au moins une enceinte de confinement,
- une sortie aval de rejet d'air vers l'extérieur de la au moins une salle principale,
- au moins un clapet d'air chaud ménagé dans le conduit en un emplacement destiné, une fois la cheminée installée en situation dans le centre, à se trouver dans la au moins une salle principale ou dans la au moins une salle de mélange, l'ouverture et la fermeture du clapet d'air chaud étant commandées par des moyens de régulation thermique associés à des moyens de mesure de température de l'air de la salle principale.

Selon une réalisation, la cheminée d'extraction d'air chaud comporte :
- au moins un clapet d'air chaud ménagé dans le conduit en un emplacement destiné, une fois la cheminée installée en situation dans le centre, à se trouver dans la au moins une salle principale,
- et au moins un clapet d'air chaud ménagé dans le conduit en un emplacement destiné, une fois la cheminée installée en situation dans le centre, à se trouver dans la au moins une salle de mélange.

Selon une réalisation, le conduit a une section transversale intérieure dont la surface est la plus grande vers l'entrée amont d'extraction d'air et dont la surface est la plus petite vers la sortie aval de rejet d'air vers l'extérieur de la au moins une salle principale;

Selon une réalisation, la cheminée comporte en outre des moyens de fixation à la au moins une enceinte de confinement et/ou au plafond de la au moins une salle principale et/ou au plancher de la au moins une salle de mélange et/ou au plafond de la au moins une salle de mélange et/ou au plafond de la salle chaude de mélange.

Selon une réalisation, le conduit comporte une garniture d'isolation thermique.

Selon une réalisation, la cheminée comporte deux tronçons distincts séparés, un tronçon amont ayant l'entrée amont d'extraction et une sortie aval intermédiaire, et un tronçon aval ayant une entrée amont intermédiaire et la sortie aval de rejet.

On décrit maintenant plusieurs modes de réalisation de l'invention à l'aide des dessins, dans lesquels :
- La figure 1 est une vue schématique en coupe par un plan vertical d'un centre de traitement de données selon l'invention selon une réalisation possible, cette vue schématique illustrant également une cheminée entrant dans la réalisation d'un tel centre et le procédé de conditionnement d'air d'un centre.
- La figure 2 est une vue schématique en coupe par un plan vertical d'un centre de traitement de données selon l'invention selon une autre réalisation possible.

L'invention concerne un centre 1 comportant des équipements 2 énergivores, tels que des équipements électroniques, informatiques ou de télécommunications. Un tel centre est par exemple un centre de traitement de données, mais l'invention s'applique à tout autre type de centre comportant des équipements 2 énergivores.

L'invention a plus spécialement pour objet le centre 1 lui-même, une cheminée d'extraction d'air chaud 3 dont il est pourvu et le procédé de conditionnement d'air d'un tel centre, celui-ci s'inférant de la structure et de fonctionnalité du centre 1 et de la cheminée 3. L'invention permet de réduire la consommation d'énergie liée au conditionnement d'air requis par l'exploitation d'un tel centre 1.

Un centre 1 comportant une ou plusieurs salles principales 4, telles que des salles informatiques.

Une telle salle principale 4 est limitée par un plancher 4a et le plus souvent un faux-plancher 4b placé au dessus, avec entre eux un espace 4c, des murs ou cloisons 5 et un plafond 6. Elle forme et délimite un espace interne 7.

Dans cet espace 7 sont disposés, reposant sur le faux-plancher 4b, plusieurs rangées de baies 8 sur lesquelles sont installés les équipements fonctionnels énergivores 2, le plus souvent en nombre. Dans les réalisations illustrées par les figures, il est représenté de façon schématiques deux blocs symbolisant deux rangées de baies 8 et d'équipements fonctionnels 2.

Par exemple, dans le cas d'un centre 1 de traitement de données, ces équipements fonctionnels 2 sont des équipements électroniques, informatiques ou de télécommunications.

Une rangée de baies 8 et d'équipements fonctionnels 2 présente d'un côté une face avant 9 et du côté opposé, une face arrière 10.

Des passages d'entrée d'air 9a sont situés fonctionnellement du côté de la face avant 9. Des passages de sortie d'air 10a sont situés du côté de la face arrière 10.

Les baies 8, les équipements 2, comportent des moyens 11 de refroidissement par ventilation associés aux passages d'entrée et de sortie 9a, 10a, représentés de façon purement symbolique. De façon typique, ces moyens 11 de refroidissement par ventilation sont de type dynamique, tels que ventilateurs intégrés aux baies 8, aux équipements 2 ou de type statique, tels que des passages profilés formant venturi.

Selon une disposition connue deux rangées adjacentes 12a, 12b de baies 8 et équipements fonctionnels 2 sont parallèles entre elles et leurs faces dos à dos sont les faces arrière 10.

Une telle disposition permet de définir un couloir 13, limité par les faces arrière 10 en vis-à-vis. Il est entendu que le plus souvent il est prévu plusieurs couloirs chauds 13, notamment disposés parallèlement les uns aux autres, cette disposition n'étant donnée qu'à titre purement exemplatif et nullement limitatif.

Le couloir 13 est qualifié de chaud pour la raison que la température de l'air qui s'y trouve - T₃ - est supérieure à la température - T₂ - de l'air tempéré se trouvant dans la partie 14 de la salle principale 4 extérieure aux couloirs chauds 13.

La partie 14 forme un espace extérieur aux baies 8 et équipements fonctionnels 2 dans lequel l'air à température - T₂ - peut se trouver et circuler. Cette partie 14 est située devant les faces avant 9 et les passages 9a d'entrée d'air qui, ainsi, sont respectivement accessibles depuis et débouchant dans la partie 14. Cette partie 14 est située également au-dessus des baies 8 dont les faces supérieures (ou toits) 15 sont écartées en-dessous du plafond 6.

De leur côté, les faces arrière 10 sont situées dans et accessibles par les couloirs chauds 13 où débouchent les passages 10a de sortie d'air.

Les couloirs chauds 13 font partie d'une ou de plusieurs enceintes de confinement d'air chaud 16, isolées de la partie 14, laquelle est extérieure à cette ou ces enceintes de confinement 16.

Une cheminée d'extraction d'air chaud 3 a, d'une part, une entrée amont d'extraction 17a communiquant avec une enceinte de confinement 16. Elle a, d'autre part, une sortie aval de rejet 17b de rejet de l'air provenant de la cheminée 3 vers l'extérieur de la salle principale 4. Cette sortie aval de rejet 17b est située à l'extérieur du centre 1, par exemple en partie haute dans une zone dégagée pour ne pas entraver le rejet.

L'enceinte de confinement 16 est fermée au-dessus du couloir chaud 13 par la cheminée d'extraction d'air chaud 3 qui dans cette zone forme un collecteur comportant l'entrée amont d'extraction 17a.

L'enceinte de confinement 16 est fermée à chacune de ses deux extrémités, avec prévision d'une porte 18 située à chacune des extrémités des rangées de baies 8. Lorsque le centre 1 est en fonctionnement, les portes 18 sont normalement fermées. Elles sont ouvertes temporairement pour permettre d'entrer dans ou de sortir du couloir chaud 13 correspondant, lorsqu'il est nécessaire d'accéder aux faces arrières 10 des équipements fonctionnels 2 qui s'y trouvent.

L'enceinte de confinement 16 est également fermée, le cas échéant, entre des équipements fonctionnels 2 installés quand un ou d'autres éléments fonctionnels 2 ne sont pas encore installés entre eux, avec prévision d'au moins un plastron, par exemple placé sur la face avant 9.

Le centre 1 comporte également des moyens de conditionnement d'air. Ces moyens de conditionnement d'air ont pour fonction, pour des impératifs techniques, de modifier, contrôler et réguler les conditions climatiques de l'air atmosphérique des salles principales 4.

Plus précisément, ces moyens de conditionnement d'air sont choisis, calculés, agencés, commandés et réglés de manière à procurer aux faces avant 9 et aux passages d'entrée d'air 9a des équipements fonctionnels 2 de l'air filtré dont le débit, la température T₂ et le degré hygrométrique sont maintenus ou compris dans les plages de débits, de températures et de degrés hygrométriques adaptées au fonctionnement optimal des équipements fonctionnels 2.

En effet, il est établi que le conditionnement de l'air ambiant des équipements fonctionnels 2 des centres de traitement de données est un facteur clé déterminant pour le fonctionnement optimal de ces équipements 2 et donc du centre 1 lui-même.

Par exemple, la plage de températures T₂ demandée est de l'ordre de 21°C, pouvant avoir des tolérances faibles de +/- 1 °C ou plus larges en fonction des spécificités des équipements 2 et l'humidité relative doit être de l'ordre de 50% à 60% ou 35 - 70, également selon les situations.

Selon l'invention, les moyens des moyens de conditionnement d'air aptes à procurer aux équipements fonctionnels 2 de l'air dont le débit est maintenu dans la plage de débits adaptée au fonctionnement optimal des équipements fonctionnels 2 sont constitués par la combinaison des moyens 11 de refroidissement et de moyens 19 de convection naturelle équipant le centre 1. Avec une telle réalisation, le centre 1 peut être dépourvu de ventilateurs d'extraction d'air chaud et/ou de ventilateurs d'amenée d'air frais, autres que ceux dont sont éventuellement pourvus les équipements fonctionnels 2.

Dans des conditions optimales de fonctionnement les moyens des moyens de conditionnement d'air aptes à procurer aux équipements fonctionnels 2 de l'air dont le débit est maintenu dans la plage de débits adaptée au fonctionnement optimal des équipements fonctionnels 2 ne comprennent que substantiellement la combinaison des moyens 11 et 19.

Les moyens de conditionnement d'air comprennent une ou plusieurs salles de mélange d'air 20.

Une telle salle de mélange 20 est limitée par un plancher 21 a, des murs ou cloisons 21 b et un plafond 21 c. Elle forme et délimite un espace interne 22,

La salle de mélange 20 comporte une ou plusieurs ouvertures d'amenée d'air extérieur 23, par exemple ménagés dans ses murs ou cloisons 21 b. Ces ouvertures 23 sont de grandes dimensions, de manière à ne pas entraver l'amenée d'air extérieur. Ces ouvertures 23 sont équipées de filtres 23a adaptés à la qualité de l'air requis pour la salle principale 4. Ces filtres 23a sont eux-aussi surdimensionnés pour minimiser la perte de charge qu'ils occasionnent et donc ne pas entraver l'amenée d'air extérieur, par convection naturelle.

Les ouvertures 23 sont adaptées et ont pour fonction d'assurer par convection naturelle et uniquement par ce moyen, une amenée d'air extérieur à température variable T₁ dans la salle de mélange 20.

La température T₁ est bien entendu fonction des conditions climatiques à l'extérieur du centre 1.

L'espace interne 22 de la salle de mélange 20 constitue un volume de mélange d'air.

En outre, il est prévu des moyens 24, sur lesquels on reviendra par la suite, adaptés pour produire dans la salle de mélange 20 de l'air à la température T₂, quelle que soit la température T₁. A cet effet, on ajoute dans la salle de mélange une quantité appropriée d'air à une température supérieure à la température T₁, ou à une température inférieure à la température T₁Cet ajout d'air est commandé et réglé en fonction des besoins en air à la température T₂ des équipements fonctionnels 2 se trouvant dans la salle principale 4,

D'une part la salle de mélange 20 est de dimensions et de capacité de mélange et d'autre part les ouvertures 23 sont de dimensions déterminées de manière à permettre, à partir du flux d'air amené à la température T₁ et du flux d'air ajouté à température supérieure ou inférieure à T₁, de produire un flux de mélange d'air à la température T₂, qui est celle adaptée au flux maximal estimé ou souhaité d'air à température T₂ pour alimenter la au moins une salle principale 4.

Un ou plusieurs passages de communication 25 sont ménagés entre la ou les salles de mélange 20 et la ou les salles principales 4.

Ces passages de communication 25 sont adaptés et ont pour fonction d'assurer par convection naturelle et uniquement par ce moyen, le passage de l'air à température T₂ produit dans la salle de mélange 20 dans la partie 14 de la salle principale 4.

A cet effet, les passages de communication 25 sont situés hors de la ou des enceintes de confinement 16.

La salle de mélange est fermée, à l'exception des ouvertures 23, des passages 25 et des ouvertures, évents ou analogues faisant partie des moyens 24 pour produire dans la salle de mélange 20 de l'air à la température T₂.

La ou les cheminées 3 sont adaptées et ont pour fonction d'assurer par convection naturelle et uniquement par ce moyen, l'extraction de l'air chaud à température T₃ de la ou des enceintes de confinement 16, puis de le rejeter à l'extérieur de la salle principale 4 et à l'extérieur du centre 1.

Avec les dispositions qui précèdent, on crée un circuit d'air ouvert entre, en amont, la ou les ouvertures d'amenée d'air extérieur 23 et, en aval, la ou les sorties aval de rejet 17b.

La disposition respective de la salle principale 4, de la salle de mélange 20, des ouvertures 23 et des passages 25 peut faire l'objet de plusieurs réalisations.

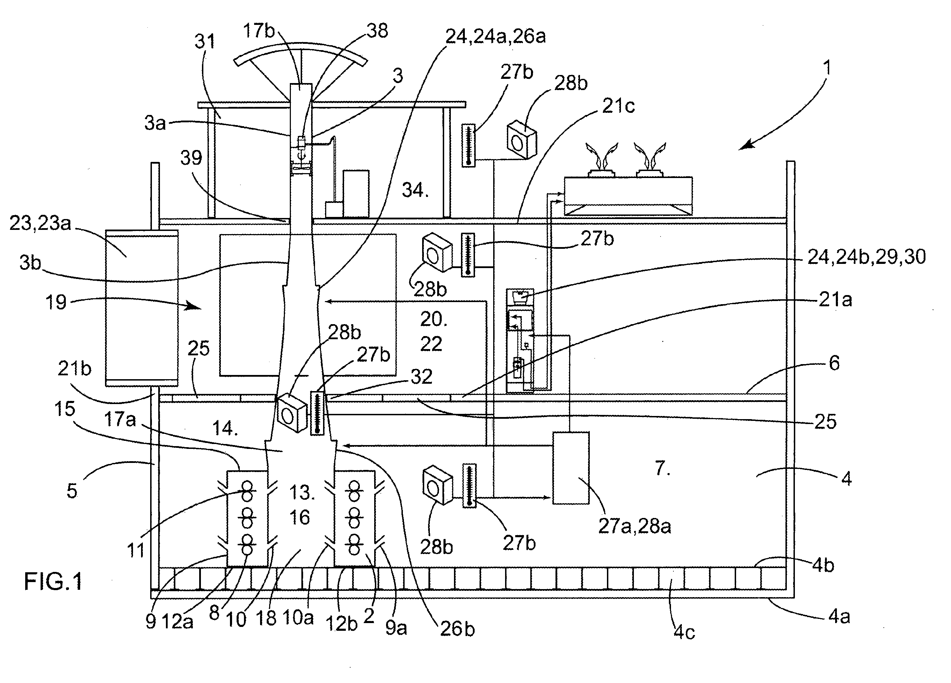

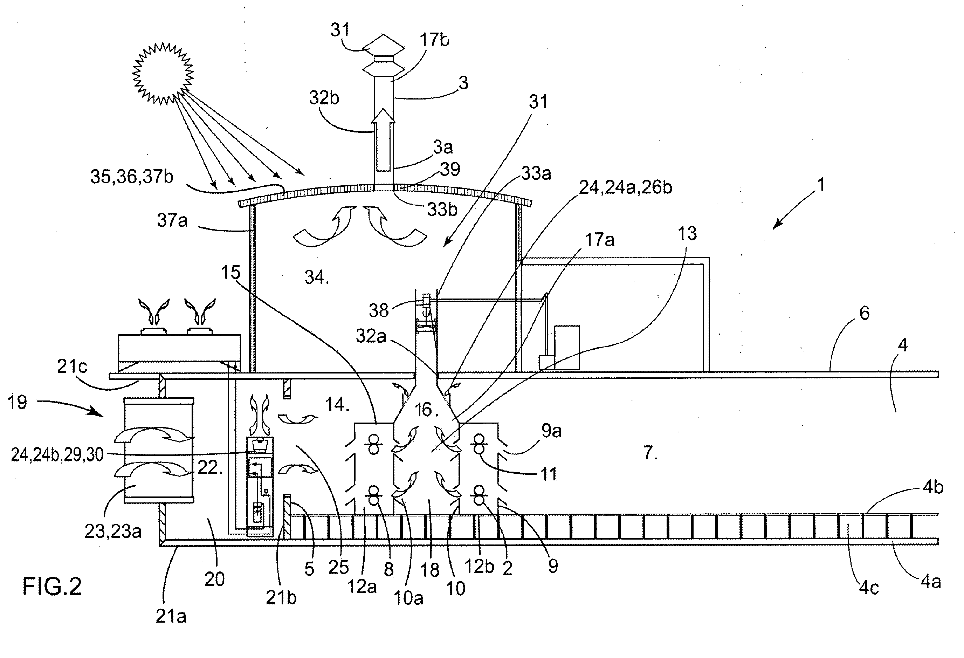

Par exemple, d'une part, selon les cas, un passage de communication 25 est ménagé dans le plafond 6 (figure 1) ou dans un mur 5 (figure 2) d'une salle principale 4, hors de toute cheminée d'extraction d'air chaud 3. D'autre part, selon les cas, un passage de communication 25 est ménagé dans un plancher 21a (figure 1) ou dans un mur 21 b (figure 2) d'une salle de mélange 20.

Préférentiellement, une salle de mélange 20 est située à proximité d'une salle principale 4. Plus précisément, une salle de mélange 20 jouxte une salle principale 4.

Selon les cas, une salle de mélange 20 est située au-dessus (figure 1) ou à côté (figure 2) d'une salle principale 4.

Ainsi, dans le cas de la figure 1, le passage de communication 25 est ménagé d'une part dans le plafond 6 de la salle principale 4 et d'autre dans le plancher 21a de la salle de mélange 20, la salle de mélange 20 étant située au-dessus de, et plus particulièrement juste au-dessus de la salle principale 4. Le conduit 3a de la cheminée d'extraction d'air chaud 3 traverse alors la salle de mélange 20 et il comporte une garniture d'isolation thermique 3b.

Dans le cas de la figure 2, le passage de communication 25 est ménagé d'une part dans un mur 5 de la salle principale 4 et d'autre part dans un mur 21 b de la salle de mélange 20, la salle de mélange 20 étant située à côté de, et plus particulièrement juste à côté de la salle principale 4.

On décrit maintenant les moyens 24 pour produire dans la salle de mélange 20 de l'air à la température T₂, quelle que soit la température T₁ par ajout d'air à une température supérieure ou inférieure à la température T₁

Dans une réalisation, les moyens 24a pour produire de l'air à la température T₂ par ajout d'air à température supérieure à T₁ comprennent un ou plusieurs clapets d'air chaud 26a associés à la cheminée d'extraction d'air chaud 3. Un ou de tels clapets d'air chaud 26a sont situés dans la salle de mélange 20. L'ouverture et la fermeture des clapets d'air chaud 26a sont commandées par des moyens de régulation thermique 27a associés à des moyens de mesure de température de l'air 28a.

Dans une réalisation, les moyens 24a ne comprennent substantiellement que et même plus particulièrement sont constitués par les clapets d'air chaud 26a en question et les moyens 27a et 28a.

Dans une autre réalisation possible, les moyens 24a comprennent, ou ne comprennent substantiellement que et même plus particulièrement sont constitués par des clapets d'air chaud 26b associés également à la cheminée d'extraction d'air chaud 3, mais situés dans la salle principale 4, dans sa partie 14.

Comme précédemment, l'ouverture et la fermeture de ces clapets d'air chaud 26b sont commandées par les moyens de régulation thermique 27a associés à des moyens de mesure de température de l'air 28a.

Dans une autre réalisation possible, les moyens 24a comprennent substantiellement et plus particulièrement sont constitués par, les clapets d'air chaud 26a situés dans la salle de mélange 20 et les clapets d'air chaud 26b situés dans la salle principale 4, avec les moyens 27a et 28a associés.

Les moyens 24b pour produire de l'air à la température T₂ par ajout d'air à température inférieure à T₁ comprennent un ou plusieurs climatiseurs d'air 29, situés dans l'une des ou dans les salles de mélange 20.

Le fonctionnement des climatiseurs 24b est commandé par les moyens de régulation thermique 27a associés aux moyens de mesure de température de l'air 28a.

Dans une réalisation, les moyens 24b ne comprennent substantiellement que et même plus particulièrement sont constitués par le climatiseur 29 en question et les moyens 27a et 28a.

Les moyens des moyens de conditionnement d'air aptes à procurer aux équipements fonctionnels de l'air dont le degré hygrométrique est maintenu dans la plage de degrés hygrométriques adaptée au fonctionnement optimal des équipements fonctionnels comprennent des moyens humidificateurs / déshumidificateurs 30 tels qu'ils produisent dans la ou dans les salles de mélange 20, alternativement ou cumulativement dans la ou dans les salles principales de l'air au degré hygrométrique souhaité. A cet effet, ils ajoutent de l'air humidifié ou ils ajoutent de l'air déshumidifié au flux d'air amené par les ouvertures 23, en fonction de l'humidité relative de celui-ci et de l'humidité relative souhaitée pour l'air qui est dirigé vers la partie 14 de la ou des salles principales 4.

Ces moyens humidificateurs / déshumidificateurs 30 peuvent être couplés, associés ou intégrés au climatiseur 29.

Le fonctionnement des moyens humidificateurs / déshumidificateurs 30 est commandé par des moyens de régulation hygrométrique 27b associés aux moyens de mesure de l'hygrométrie de l'air 28b.

Les moyens de régulation thermique 27a peuvent être associés aux moyens de régulation hygrométrique 27b dans une armoire de régulation.

Les moyens de mesure de température de l'air 28a peuvent être associés aux moyens de mesure de l'hygrométrie de l'air 28b dans un ensemble de mesure.

Selon un développement, (Figure 2) le centre 1 comporte en outre des moyens 31 d'assistance à la convection naturelle associés fonctionnellement et structurellement à la ou aux cheminée d'extraction d'air chaud 3.

Dans la réalisation de la figure 1, les moyens 31 d'assistance à la convection naturelle sont un dispositif d'aspiration statique ou stato-dynamique monté sur la sortie aval de rejet 17b de la cheminée d'extraction d'air chaud 3.

On entend par dispositif d'aspiration statique d'assistance à la convection naturelle, un dispositif qui ne comporte aucune pièce en mouvement et ne consomme pas d'énergie produite à cette fin. Un tel dispositif peut être constitué par exemple par des passages profilés formant venturi. On entend par dispositif d'aspiration stato-dynamique d'assistance à la convection naturelle, un dispositif qui comporte une ou des pièces en mouvement sous l'effet des conditions aérauliques (vent, pression...), mais ne consomme pas d'énergie produite à cette fin. Un tel dispositif peut être constitué par exemple par une turbine.

On se réfère maintenant à la figure 2 qui illustre une autre réalisation possible des moyens 31 d'assistance à la convection naturelle.

Dans cette réalisation, les moyens 31 comprennent la cheminée d'extraction d'air chaud qui comporte deux tronçons distincts séparés, à savoir un tronçon amont 32a et un tronçon aval 32b.

Le tronçon amont 32a comporte l'entrée amont d'extraction 17a et une sortie aval intermédiaire 33a.

Le tronçon aval ayant 32b comporte une entrée amont intermédiaire 33b et la sortie aval de rejet 17b.

Préférentiellement, les deux tronçons 32a et 32b sont écartés axialement de manière que l'air sortant de la sortie aval intermédiaire 33a soit efficacement mélangé avec l'air de la salle chaude de mélange 34 avant que d'entrer dans l'entrée amont intermédiaire 33b.

Dans la réalisation considérée, les moyens 31 comprennent également une ou plusieurs salles chaudes de mélange d'air 34.

Une telle salle chaude de mélange 34 est adaptée pour que l'air qui s'y trouve soit à une température T₄, supérieure à la température T₃.

En outre, une telle salle chaude de mélange 34 est agencée avec la cheminée d'extraction d'air chaud 3 en deux tronçons 32a et 32b de manière à être interposée entre ces deux tronçons 32a et 32b.

Ainsi, la sortie aval intermédiaire 33a et l'entrée amont intermédiaire 33b sont situées et débouchent dans la salle chaude de mélange 34, laquelle est fermée à l'exception de la sortie aval intermédiaire 33a et de l'entrée amont intermédiaire 33b.

Les moyens 31 comprennent également, associés à la ou aux salles chaudes de mélange 34, des moyens 35 aptes à élever de T₃ T₄ la température de l'air se trouvant dans la ou dans les salles chaudes de mélange 34.

Dans la réalisation de la figure 2, ces moyens 35 sont statiques en ce sens qu'ils ne comportent pas de pièces en mouvement et ne consomment pas d'énergie produite à cette fin. De tels moyens 35 peuvent comprendre ou être constitués par des moyens de chauffage d'origine solaire.

A cet effet, il est prévu par exemple, une ou des parois de verre ou analogue 36 sur les murs 37a ou la couverture de plafond 37b d'une salle chaude de mélange 34. Ainsi, une telle salle chaude de mélange 34 forme une sorte verrière chauffée par le soleil, ce qui permet de chauffer l'air qui s'y trouve. Par suite, la convention naturelle qui existait déjà en l'absence des moyens 31 se trouve aidée, assistée et renforcée par la présence de ces moyens.

Bien entendu, on peut combiner les moyens 31 d'assistance à la convection naturelle de type aspiration statique ou stato-dynamique selon la réalisation de la figure 1 et les moyens 31 de chauffage d'origine solaire selon la réalisation de la figure 2.

Une salle chaude de mélange 34 est préférentiellement située en hauteur, par exemple au-dessus d'une salle de mélange 20 (figure 1) ou au-dessus d'une salle principale 4 (figure 2).

Selon un autre développement, le centre 1 comporte en outre un ou plusieurs dispositifs de récupération de l'énergie 38 de l'air chaud extrait par la ou par les cheminées d'extraction d'air chaud 3.

Un tel dispositif de récupération d'énergie 38 est placé au moins pour partie dans le conduit 3a de la cheminée d'extraction d'air chaud 3.

Dans la réalisation de la figure 1, le dispositif de récupération d'énergie 38 est placé vers la sortie aval de rejet 17b. Plus spécialement, il peut se trouver au niveau d'une salle chaude de mélange 34.

Dans la réalisation de la figure 2, le dispositif de récupération d'énergie 38 est placé vers la sortie aval intermédiaire 33a. Comme précédemment, il peut se trouver au niveau d'une salle chaude de mélange 34.

Un tel dispositif de récupération d'énergie 38 est par exemple du type comportant des pales entraînées en rotation par le flux d'air, montées sur un rotor d'une génératrice de courant électrique.

La cheminée d'extraction d'air chaud 3 est agencée pour maximiser la convection naturelle recherchée. La longueur et la section du conduit 3a sont déterminés en conséquence. En particulier, dans les réalisations représentées sur les figures 1 et 2, le conduit 3a a une section transversale intérieure dont la surface est la plus grande vers l'entrée amont d'extraction 17a et dont la surface est la plus petite vers la sortie aval de rejet 17b.

Selon les réalisations, la cheminée d'extraction d'air chaud 3 comporte un ou plusieurs clapets 26a, un ou plusieurs clapets 26b, un ou plusieurs clapets 26a et 26b.

Une telle cheminée d'extraction d'air chaud 3 comporte en outre des moyens de fixation 39 à la ou aux enceintes de confinement 16, au plafond 6, au plancher 21a, au plafond 21c, au plafond 37b.

Comme indiqué, le conduit 3a de la cheminée d'extraction d'air chaud 3 comporte avantageusement une garniture d'isolation thermique 3b, surtout si la cheminée d'extraction d'air chaud 3 traverse la salle de mélange 20.

Comme indiqué, dans une réalisation possible, la cheminée d'extraction d'air chaud 3 comporte deux tronçons distincts séparés, un tronçon amont 32a et un tronçon aval 32b.

Le procédé de conditionnement d'air du centre 1 s'infère de la structure même du centre.

Pour assurer un débit d'air dans la plage de débits adaptée au fonctionnement optimal des équipements fonctionnels 2, on met en oeuvre en combinaison des moyens 11 de refroidissement par ventilation des équipements fonctionnels 2 et de moyens 19 de convection naturelle équipant le centre 1.

En outre, on amène de l'air extérieur à température T₁ à une salle de mélange 20 par convection naturelle, on mélange l'air extérieur ainsi amené avec une quantité appropriée d'air à température supérieure à T₁ ou avec une quantité appropriée d'air à température inférieure à T₁ et on produit ainsi de l'air à la température T₂, on amène l'air à la température T₂ de la salle de mélange 20 à la partie 14 d'une salle principale 4, on extrait l'air chaud de l'enceinte de confinement 16 par convection naturelle, et on rejette l'air chaud extrait.

Ce faisant, on réalise un circuit ouvert d'air entre l'ouverture d'amenée d'air 23 la sortie aval de rejet de l'air chaud 17b, via les passages d'entrée d'air 9a et les passages de sortie d'air 10a et les moyens 11 de refroidissement.

Selon les cas on amène l'air à la température T₂ de la salle de mélange 20 à la partie 14 de la salle principale 4 par un mouvement généralement descendant et/ou un mouvement généralement horizontal, en tout état de cause un mouvement autre qu'un mouvement généralement ascendant à partir du plancher 4a ou du faux-plancher 4b de la salle principale 4.

Selon une réalisation, pour mélanger l'air extérieur amené dans la salle de mélange 20 avec une quantité appropriée d'air à température supérieure à T₁, on prélève une quantité appropriée d'air chaud extrait d'une enceinte de confinement 16 par convection naturelle.

Le cas échéant, on assiste de façon statique la convection naturelle dans la cheminée d'extraction d'air chaud 3.

Le cas échéant, on amène de l'air chaud d'une enceinte de confinement 16 par convection naturelle par un tronçon amont 32a d'une cheminée d'extraction d'air chaud 3, on amène l'air se trouvant dans une salle chaude de mélange 34 à une température T₄, supérieure à la température T₃, on extrait l'air chaud de la salle chaude de mélange 34 par convection naturelle, et on rejette l'air extrait par le tronçon aval 32b de la cheminée d'extraction d'air chaud 3.

Le cas échéant, on récupère de l'énergie de l'air chaud extrait par une cheminée d'extraction d'air chaud 3.

## Revendications

1. Cheminée d'extraction d'air chaud (3), spécialement destinée à être intégrée à un centre (1), tel que centre (1) de traitement de données, comportant au moins une salle principale (4) où se trouvent une pluralité de rangées de baies (8) sur lesquelles sont installés une pluralité d'équipements fonctionnels (2) énergivores, tels que des équipements électroniques, informatiques ou de télécommunications, ayant d'une part des passages d'entrée d'air (9a) situés fonctionnellement du côté de leur face avant (9) et des passages de sortie d'air (10a) situés du côté de leur face arrière (10) et d'autre part des moyens (11) de refroidissement par ventilation associés aux passages d'entrée et de sortie (9a, 10a), centre dans lequel :
- la disposition des baies (8) et des équipements fonctionnels (2) est telle qu'une paire au moins de deux rangées adjacentes (12a, 12b), dont les faces dos à dos des équipements fonctionnels (2) sont les faces arrière (10), définit un couloir chaud (13) limité par ces faces arrière (10) et où sont accessibles les passages de sortie d'air (9b), dans lequel l'air est chaud, à une température T₃ supérieure à la température T₂ de l'air tempéré se trouvant dans la partie (14) de la salle principale (4) extérieure au ou aux couloirs chauds (13), et depuis laquelle sont accessibles les faces avant (9) et les passages d'entrée d'air (9a),
- il est prévu des moyens de conditionnement d'air aptes à procurer aux faces avant (9a) des équipements fonctionnels (2) de l'air filtré dont le débit, la température T₂ et le degré hygrométrique sont maintenus ou compris dans les plages de débits, de températures et de degrés hygrométriques adaptées au fonctionnement optimal des équipements fonctionnels (2),
- le ou les couloirs chauds (13) font partie d'une ou de plusieurs enceintes de confinement d'air chaud (16) isolées de la partie (14) de la salle principale (4) extérieure à cette ou ces enceintes de confinement (16),
- les moyens des moyens de conditionnement d'air aptes à procurer aux équipements fonctionnels (2) de l'air dont le débit est maintenu dans la plage de débits adaptée au fonctionnement optimal des équipements fonctionnels (2) comprennent au moins une salle de mélange d'air (20) et la combinaison des moyens (11) de refroidissement par ventilation des équipements fonctionnels (2) et de moyens (19) de convection naturelle équipant le centre (1), tels que le centre (1) est dépourvu de ventilateurs d'extraction d'air chaud et/ou de ventilateurs d'amenée d'air frais, autres que ceux dont sont pourvus les équipements fonctionnels (2),
cheminée comportant :
- un conduit (3a) de longueur et de section aptes à maximiser la circulation de l'air par convection naturelle,
- une entrée amont d'extraction d'air (17a) apte à communiquer avec la au moins une enceinte de confinement (16),
- une sortie aval de rejet (17b) d'air vers l'extérieur de la au moins une salle principale (4),
- au moins un clapet d'air chaud (26b, 26a) ménagé dans le conduit (3a) en un emplacement destiné, une fois la cheminée (3) installée en situation dans le centre (1), à se trouver dans la au moins une salle principale (4) ou dans la au moins une salle de mélange (20), l'ouverture et la fermeture du clapet d'air chaud (26b, 26a) étant commandées par des moyens de régulation thermique (27a) associés à des moyens de mesure de température de l'air (28a) de la salle principale.

2. Cheminée d'extraction d'air chaud (3), selon la revendication 1, **caractérisé par le fait qu'**elle comporte :
- au moins un clapet d'air chaud (26b) ménagé dans le conduit (3a) en un emplacement destiné, une fois la cheminée (3) installée en situation dans le centre (1), à se trouver dans la au moins une salle principale (4),
- et au moins un clapet d'air chaud (26a) ménagé dans le conduit (3a) en un emplacement destiné, une fois la cheminée (3) installée en situation dans le centre (1), à se trouver dans la au moins une salle de mélange (20).

3. Cheminée d'extraction d'air chaud (3) selon l'une quelconque des revendications 1 et 2, **caractérisée par le fait que** le conduit (3a) a une section transversale intérieure dont la surface est la plus grande vers l'entrée amont d'extraction d'air (17a) et dont la surface est la plus petite vers la sortie aval de rejet (17b) d'air vers l'extérieur de la au moins une salle principale (4).

4. Cheminée d'extraction d'air chaud (3) selon l'une quelconque des revendications 1 à 3, **caractérisée par le fait qu'**elle comporte en outre des moyens (39) de fixation à la au moins une enceinte de confinement (16) et/ou au plafond (6) de la au moins une salle principale (4) et/ou au plancher (21a) de la au moins une salle de mélange (20) et/ou au plafond (21c) de la au moins une salle de mélange (20) et/ou au plafond (37b) de la salle chaude de mélange (34).

5. Cheminée d'extraction d'air chaud (3) selon l'une quelconque des revendications 1 à 4, **caractérisée par le fait que** le conduit (3a) comporte une garniture d'isolation thermique (3b).

6. Cheminée d'extraction d'air chaud (3) selon l'une quelconque des revendications 1 à 5, **caractérisée par le fait qu'**elle comporte deux tronçons distincts séparés, un tronçon amont (32a) ayant l'entrée amont d'extraction (17a) et une sortie aval intermédiaire (33a), et un tronçon aval (32b) ayant une entrée amont intermédiaire (33b) et la sortie aval de rejet (17b).

## Patentansprüche

1. Heißluft-Abzugskamin (3), der speziell konzipiert ist, so dass er in ein Center (1) integriert werden kann, wobei es sich um ein Datenverarbeitungscenter (1) handelt, das mindestens aus einem Hauptraum (4) besteht, wo diverse Reihen von Schränken (8) untergebracht sind für unterschiedliche energieintensive Funktionseinrichtungen (2), wie zum Beispiel Elektronik-, Datenverarbeitungs- oder Telekommunikationseinrichtungen, die einerseits mit Lufteinlässen (9a) versehen sind, die sich funktionsgerecht seitlich vorne (9) befinden, Luftauslässen (10a), die sich seitlich hinten (10) befinden sowie den Umluftkühlvorrichtungen (11), die mit den Luftein- und auslässe (9a, 10a) verbunden sind. Das Center wird wie folgt ausgestattet mit:
- Anordnung von Schränken (8) und Funktionseinrichtungen (2), so dass ein Paar von mindestens zwei nebeneinanderliegenden Reihen (12a, 12b), in denen die Funktionseinrichtungen (2) Rücken an Rücken zur Vorder-, beziehungsweise Rückseite (10) hin installiert sind, so dass ein heißer Mittelgang (13) entsteht, der durch die Rückseite (10) begrenzt ist und durch den die Luftauslässe (9b) zugänglich sind. Hierin befindet sich heiße Luft mit einer Temperatur T3, die heißer ist als die mildere Luft mit einer Temperatur T2, die man in einem Teil (14) des äußeren Hauptraumes (4) oder der heißen Mittelgänge (13) vorfindet, von denen aus die Vorderseiten (9) und die Lufteinlässe (9a) zugänglich sind.
- Eine Klimaanlage ist vorgesehen, die die Vorderseiten (9a) der Funktionseinrichtungen (2) mit gefilterter Luft versorgt, wobei Leistung, Temperatur T2 und relative Luftfeuchtigkeit gewährleistet werden durch Leistungs-, Temperatur- und Luftfeuchtigkeitswerte, die für einer optimalen Betrieb der Funktionseinrichtungen (2) erforderlich sind.
- Der heiße Mittelgang ist /die heißen Mittelgänge (13) sind Bestandteil(e) eines oder mehrerer Heißluft-Schutzmäntel (16), der/die zum Teil (14) des äußeren Hauptraumes (4) hin isoliert ist/sind.
- Die Klimaanlagen, die die Funktionseinrichtungen (2) mit Luft versorgen und deren Leistung für einen optimalen Betrieb der Funktionseinrichtungen (2) ausgelegt sind, beinhalten mindestens einen Luftmischraum (20) und eine Kombination von Umluftkühlung (11) der Funktionseinrichtungen (2) mit natürlicher Wärmekonvektion (19), die für das Center (1) vorgesehen ist, wobei für das Center (1) kleine Heißluft-Saug- und/oder Frischluft-Ventilatoren vorgesehen sind. Hiervon ausgenommen sind diejenigen, die für die Funktionseinrichtungen (2) vorgesehen sind.
Der Kamin wird ausgestattet mit:
- einer Leitung (3a) deren Lange und Durchmesser für eine maximale Luftzirkulation durch natürliche Warmekonvektion ausgelegt ist;
- einen oberen Sauglufteinlass (17a), der an mindestens einen Schutzmantel (16) abgeschlossen ist;
- einen unteren Abluft-Auslass (17b), der von mindestens einem Hauptraum (4) nach außen fuhrt,
- mindestens einer Heißlaftklappe (26b, 26a) in der Leitung (3a) an einer bestimmten Stelle, sobald der Kamin (3) im Center (1) in mindestens einem Hauptraum (4) oder mindestens einem Luftmischrauir (20) installiert ist. Das Öffnen und Schließen der Heißluftklappe (26b, 26a) erfolgt durch Wärmergler (27a), die verbunden sind mit den Lufttemperatur-Messgeraten (23a) im Hauptraum.

2. Der Heißluft-Abzugskamin (3) gemäß Anspruch 1 wird dadurch charakterisiert, dass er Folgendes beinhaltet :
- mindestens eine Heißluftklappe (26b) in der Leitung (3a) an einer bestimmten Stelle, sobald der Kamin (3) im Center (1) in mindestens einem Hauptraum (4) installiert ist;
- mindestens eine Heißluftklappe (26a) in der Leitung (3a) an einer bestimmten Stelle, sobald der Kamin (3) im Center (1) in mindestens einem Luftmischraum (20) installiert ist.

3. Der Heißluft-Abzugskamin (3) gemäß Anspruch 1 und 2 wird dadurch charakterisiert, dass der Innern-Querschnitt der Leitung (3a) nach außen von mindestens einem Hauptraum (4) am oberen Lufteinlass (17a) am größten ist und am unteren Abluft-Auslass (17b) am kleinsten.

4. Der Heißluft-Abzugskamin ; (3) gemäß Anspruch 1 bis 3 wird dadurch charakterisiert, dass dieser außerdem Befestigungen (39) an mindestens einem der Schutzmäntel (16), und/oder an der Decke (6) in mindestens einem Hauptraum (4), und/oder an der Decke (21a) in mindestens einem Luftmischraum (20), und/oder an der Decke (21c) in mindestens einem Luftmischraum (20), und/oder an der Decke (37b) des Heiß-Mischraumes (34) vorsieht.

5. Der Heißluft-Abzugskamin (3) gemäß Anspruch 1 bis 4 wird dadurch charakterisiert, dass für die Leitung (3a) ein Wärmeschutz (3b) vorzusehen ist.

6. Der Heißluft-Abzugskamin (3) gemäß Anspruch 1 bis 5, wird dadurch charakterisiert, dass dieser zwei unterschiedliche, separate Abschnitte hat. Der obere Abschnitt (32a) wird versehen mit einem oberen Sauglufteinlass (17a) und einem unteren Zwischenauslass (33a). Der untere Auslass (32b) wird versehen mit einem oberen Zwischeneinlass (33b) und einem unteren Luft-Auslass (17b).

## Claims

1. Hot-air extraction shaft (3), intended specifically to be integrated in a center (1), such as a data processing center (1), comprising at least one main room (4) where a number of rows of bays (8) are located, which bays hold a number of functional energy-intensive pieces of equipment (2), such as electronic, computer or telecommunications equipment, that have, on the one hand, air intake passages (9a) located functionally beside their front surface (9) and air discharge passages (10a) located beside their rear surface (10), and, on the other hand, means (11) for cooling by ventilation that are integrated into the bays (8), with functional equipment (2), by being associated with intake and discharge passages (9a, 10a), in which:
■ The arrangement of the bays (8) and functional equipment (2) is such that at least one pair of two adjacent rows (12a, 12b), of which the back-to-back surfaces of the functional equipment (2) are the rear surfaces (10), defines a hot passage (13) that is limited by these rear surfaces (10) and where the air discharge passages (9b), in which the air is hot, are accessible at a temperature T₃ that is higher than the temperature T₂ of the tempered air that is found in the portion (14) of the main room (4) that is outside of the hot passage(s) (13) and from which the front surfaces (9) and the air intake passages (9a) are accessible,
■ Air-conditioning means are provided that can provide filtered air on the front surfaces (9a) of the functional equipment (2), where said filtered air's flow rate, temperature T₂ and hygrometric degree are kept or encompassed within the ranges of flow rates, temperatures and hygrometric degrees that are suitable for the optimal operation of functional equipment (2),
■ The hot passage(s) (13) are part of one or more hot-air containment chambers (16) that are isolated from the portion (14) of the main room (4) outside of this or these containment chamber(s) (16),
■ The means of the air-conditioning means able to provide air to the functional equipment (2) whose air's flow rate is kept within the range of flow rates that are suitable for the optimal operation of the functional equipment (2), comprise at least one mixing room (20) and the combination of the ventilation cooling means (11) of the functional equipment (2) and of the natural convection means (19) with which the center (1) is equipped, such that the center (1) is lacking hot-air extraction fans and/or fresh-air intake fans other than those with which the functional equipment (2) is equipped, the hot-air extraction shaft (3) comprising:
o A pipe (3a) whose length and cross-section are arranged to maximize the circulation of the air by natural convection,
o An upstream extraction intake (17a) able to communicates with the at least one containment chamber (16)
o A downstream discharge outlet (17b) toward the outside of the main room (4),
o At least one hot-air valve (26a, 26b) arranged within the pipe (3a) in a location intended, when the shaft (3) is operationally integrated in the center (1), to be located in the at least one main room (4) and/or to be located in the at least one mixing room (20), the opening and the closing of the at least one hot-air valve (26a, 26b) being controlled by heat regulation means (27a) that are associated with air-temperature measuring means (28a) of the main room.

2. Hot-air extraction shaft (3) according to claim 1, **characterized by** the fact that it comprises:
• At least one hot-air valve (26b) arranged within the pipe (3a) in a location intended, when the shaft (3) is operationally integrated in the center (1), to be located in the at least one main room (4),
• and at least one hot-air valve (26a) arranged within the pipe (3a) in a location intended, when the shaft (3) is operationally integrated in the center (1), to be located in the at least one mixing room (20).

3. Hot-air extraction shaft (3) according to any of Claims 1 and 2, **characterized by** the fact that the pipe (3a) has an inside cross-section whose surface area is the largest toward the upstream extraction intake (17a) and whose surface area is the smallest toward the downstream discharge outlet (17b) toward the outside of the main room (4).

4. Hot-air extraction shaft (3) according to any of Claims 1 to 3, **characterized by** the fact that it also comprises means (39) for attachment to the containment chamber (16) and/or to the ceiling (6) of the at least one main room (4) and/or to the floor (21a) of the at least one mixing room (20) and/or to the ceiling (21c) of the at least one mixing room (20) and/or to the ceiling (37b) of the at least one hot mixing room (34).

5. Hot-air extraction shaft (3) according to any of Claims I to 4, **characterized by** the fact that the pipe (3a) comprises a heat insulation fixture (3b).

6. Hot-air extraction shaft (3) according to any of Claims 1 to 5, **characterized by** the fact it comprises two separate distinct segments, an upstream segment (32a) comprising the upstream extraction intake (17a) and an intermediate downstream outlet (33a), and a downstream segment (32b) comprising an intermediate upstream intake (33b) and the downstream discharge outlet (17b).
